(19) Europäisches Patentamt
European Patent Office
Office européen des brevets

(11) **EP 4 130 766 B1**

(12) **EUROPEAN PATENT SPECIFICATION**

(45) Date of publication and mention
of the grant of the patent:
**20.08.2025 Bulletin 2025/34**

(21) Application number: **20932184.3**

(22) Date of filing: **24.04.2020**

(51) International Patent Classification (IPC):
**G01R 31/36** (2020.01)   **G01R 31/367** (2019.01)
**G01R 31/392** (2019.01)   **B60L 3/00** (2019.01)
**B60L 58/10** (2019.01)   **B60L 58/16** (2019.01)

(52) Cooperative Patent Classification (CPC):
**G01R 31/392; B60L 3/0046; B60L 58/10;
B60L 58/16; G01R 31/367;** B60L 2240/547;
B60L 2240/549; B60L 2250/10; B60L 2250/16

(86) International application number:
**PCT/CN2020/086781**

(87) International publication number:
**WO 2021/212496 (28.10.2021 Gazette 2021/43)**

(54) **BATTERY DETECTION METHOD AND APPARATUS**

BATTERIEDETEKTIONSVERFAHREN UND -VORRICHTUNG

PROCÉDÉ ET APPAREIL DE DÉTECTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.02.2023 Bulletin 2023/06**

(73) Proprietor: **Shenzhen Yinwang Intelligent
Technologies Co., Ltd.
Shenzhen City, Guangdong 518129 (CN)**

(72) Inventors:
• **CHENG, Kang**
**Shenzhen, Guangdong 518129 (CN)**
• **WANG, Jiajia**
**Shenzhen, Guangdong 518129 (CN)**
• **ZHU, Zemin**
**Shenzhen, Guangdong 518129 (CN)**

(74) Representative: **Gill Jennings & Every LLP
The Broadgate Tower
20 Primrose Street
London EC2A 2ES (GB)**

(56) References cited:
WO-A1-2011/160258    CN-A- 101 010 596
CN-A- 101 512 365    CN-A- 102 043 132
CN-A- 102 313 843    CN-A- 102 901 928
CN-A- 104 777 431    CN-A- 105 866 551
CN-A- 106 772 099    CN-A- 107 329 088
CN-A- 108 258 338    CN-U- 204 758 795
JP-A- 2006 015 896    JP-A- 2007 216 707
US-A1- 2016 195 587    US-B2- 10 310 022

## Description

### TECHNICAL FIELD

This application relates to the field of battery technologies, and more specifically, to a battery detection method, an apparatus, a computer readable storage medium, and a computer program product.

### BACKGROUND

With a wide application of electric vehicles, safety accidents of lithium-ion power batteries occur frequently. Safety accidents of lithium-ion power batteries are usually characterized by sudden temperature rise, smoke, fire, and even explosion, with thermal runaway as the core. The safety accidents of lithium-ion power batteries on electric vehicles threaten the safety of people's lives and property, and seriously hinder the large-scale industrialization application of electric vehicles.

The thermal runaway of power batteries is not an instant process, but a gradual process. If battery failures can be detected in an early stage, and preventive measures can be taken in advance or vehicle owners are warned to repair their vehicles as soon as possible, personal injuries and property losses caused by thermal runaway can be avoided. Therefore, how to accurately evaluate a battery failure degree and provide a countermeasure is an urgent problem to be resolved.

US 2016/195587 A1 describes an apparatus for estimating state information of a battery. The apparatus estimates the state information from information, obtained by classifying and preprocessing battery information measured by a battery management system, using a pre-trained battery degradation model.

US 10 310 022 B2 describes a battery state estimation apparatus that determines a validity of a battery model, which is dependent on a parameter, based on state information of a battery that is estimated from battery information of the battery. The battery state estimation apparatus transmits an update request for the battery model to an external battery model provider in response to a result of the determining indicating that the battery model is invalid, receive another parameter in response to the update request, and update the battery model based on the other parameter.

CN 108 258 338 A describes a management system of a battery, comprising: a data acquisition device that acquires real-time state parameters of the battery, and a processing device disposed at a terminal that estimates at least a SOC value and/or a SOH value of the battery based on said real-time state parameters, and sends the estimated values to a cloud platform. Further, a method for managing a battery comprises: By estimating the SOC and SOH of the battery at the terminal, analyzing the estimated values and training a neural network model through the cloud platform.

## SUMMARY

This application provides a battery detection method and an apparatus. A status parameter of a battery is input into a service system that includes a failure model obtained through training, to obtain a failure degree, and the failure degree is sent to a vehicle-mounted device and/or a terminal device, so that a failure risk of the battery can be accurately evaluated, and a loss caused by a battery failure can be reduced.

According to a first aspect, a battery detection method is provided. The method includes: obtaining a first battery status parameter of a battery; determining a first failure degree based on the first battery status parameter and a failure model, where the first failure degree is used to indicate a failure degree that is of the battery and that corresponds to the first battery status parameter, the failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature; and sending a first message, where the first message includes the first failure degree.

The battery status parameter is input into a service system that includes the failure model obtained through training, to obtain the failure degree, and the failure degree is sent to a vehicle-mounted device and/or a terminal device, so that a failure risk of the battery can be accurately evaluated, and a loss caused by a battery failure can be reduced.

According to the first aspect, the determining a first failure degree based on the first battery status parameter and a failure model specifically includes: determining a battery internal resistance based on at least one parameter of the discharge voltage, the discharge current, and the charging temperature that are included in the first battery status parameter, where the battery internal resistance is used to determine the first failure degree. The battery internal resistance is estimated using a status estimation algorithm, and the battery internal resistance as well as the first battery status parameter are input into the failure model to determine the first failure degree.

A multi-dimensional battery status parameter including the battery internal resistance is input into the failure model, and the failure degree is obtained, so that accuracy of battery failure detection can be improved.

With reference to the first aspect, in some implementations of the first aspect, when the first failure degree is greater than or equal to a preset first threshold, a second message is sent, where the second message is used to indicate that the battery has a failure risk.

When a battery failure degree is greater than a preset threshold, a message is sent to remind a user that the battery has a failure risk, for example, to warn the user or to indicate a vehicle to take a coercive measure, so that personal injuries and property losses caused by the battery failure can be reduced.

With reference to the first aspect, in some implementations of the first aspect, before the determining a first failure degree based on the first battery status parameter and a failure model, the method further includes: receiving a third message, where the third message is used to request to detect the battery.

A request message is received and the battery is detected, so that user experience can be improved, and a requirement of the user for detecting the battery at any time can be met.

With reference to the first aspect, in some implementations of the first aspect, the sending a first message specifically includes: sending the first message within a first preset time after the first battery status parameter is obtained.

The battery is detected based on a preset time, for example, a specific time interval, and a detection result is sent, so that an effect of periodically detecting the battery can be achieved. This further improves user experience.

With reference to the first aspect, in some implementations of the first aspect, the method further includes: inputting the second battery status parameter into an original model, to obtain a third failure degree; adjusting a parameter of the original model, so that a deviation between the third failure degree and the second failure degree falls within a preset range; and using the original model that goes through the adjustment as the failure model.

Adjusting the failure model by using the original model can effectively improve accuracy of the failure model, and further improves accuracy of battery detection.

According to a second aspect, a battery detection method is provided, where the method includes: sending a first message, where the first message is used to request to detect a battery; receiving a second message, where the second message includes a first failure degree, the first failure degree is used to indicate a failure degree that is of the battery and that corresponds to a first battery status parameter, a failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature.

A request message used to request to detect the battery is sent to a service system, to obtain a failure degree based on the failure model, so that a battery failure risk can be accurately understood, and a loss caused by battery thermal runaway can be reduced.

Optionally, the first message may be sent by a vehicle-mounted device, a terminal device, an application APP in the terminal device, or the like.

With reference to the second aspect, in some implementations of the second aspect, a third message is received, where the third message is used to indicate that the battery has a failure risk, and the third message is sent by the service system or the terminal device when the first failure degree is greater than or equal to a first threshold.

A warning message or an indication message that is sent when the battery failure degree exceeds a threshold is received, so that a measure, such as repair or replacement, can be taken on the battery in advance, and personal injuries and property losses caused by the battery failure can be reduced.

With reference to the second aspect, in some implementations of the second aspect, the method further includes: taking a coercive action based on the third message.

Taking a coercive measure, such as deceleration and parking, based on the message sent by the service system can effectively reduce personal injuries and property losses caused by the battery failure.

With reference to the second aspect, in some implementations of the second aspect, the method further includes: displaying the second message and/or the third message by using a display apparatus.

User experience can be improved by displaying the message sent by the service system.

With reference to the second aspect, in some implementations of the second aspect, the method further includes: sending the first battery status parameter to the service system, where the first battery status parameter includes at least one of the following parameters: the discharge voltage, the discharge current, and the charging temperature.

According to a third aspect, a battery detection apparatus is provided, where the apparatus includes: a first obtaining module, configured to obtain a first battery status parameter of a battery; a first processing module, configured to determine a first failure degree based on the first battery status parameter and a failure model, where the first failure degree is used to indicate a failure degree that is of the battery and that corresponds to the first battery status parameter, the failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature; and a first sending module, configured to send a first message, where the first message includes the first failure degree.

According to the third aspect, the processing module is specifically configured to determine a battery internal resistance based on at least one parameter of the discharge voltage, the discharge current, and the charging temperature that are included in the first battery status parameter, where the battery internal resistance is used to determine the first failure degree. The battery internal resistance is estimated using a status estimation algorithm, and the battery internal resistance as well as the first battery status parameter are input into the failure model to determine the first failure degree.

With reference to the third aspect, in some implementations of the third aspect, the first sending module is further configured to send a second message when the first failure degree is greater than or equal to a preset first threshold, where the second message is used to indicate that the battery has a failure risk.

With reference to the third aspect, in some implementations of the third aspect, the apparatus further includes: a first receiving module, configured to receive a third message, where the third message is used to request to detect the battery.

With reference to the third aspect, in some implementations of the third aspect, the first sending module is specifically configured to send the first message within a first preset time after the first battery status parameter is obtained.

With reference to the third aspect, in some implementations of the third aspect, the first processing module is further configured to: input the second battery status parameter into an original model, to obtain a third failure degree; adjust a parameter of the original model, so that a deviation between the third failure degree and the second failure degree falls within a preset range; and use the original model that goes through the adjustment as the failure model.

According to a fourth aspect, a battery detection apparatus is provided. The apparatus includes: a second sending module, configured to send a first message, where the first message is used to request to detect a battery; a second receiving module, configured to receive a second message, where the second message includes a first failure degree, the first failure degree is used to indicate a failure degree that is of the battery and that corresponds to a first battery status parameter, a failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature.

With reference to the fourth aspect, in some implementations of the fourth aspect, the second receiving module is further configured to receive a third message, where the third message is used to indicate that the battery has a failure risk, and the third message is sent by a service system or a terminal device when the first failure degree is greater than or equal to a first threshold.

With reference to the fourth aspect, in some implementations of the fourth aspect, the apparatus further includes: a second processing module, configured to take a coercion action based on the third message.

With reference to the fourth aspect, in some implementations of the fourth aspect, the apparatus further includes: a display module, configured to display the second message and/or the third message by using a display apparatus.

With reference to the fourth aspect, in some implementations of the fourth aspect, the second sending module is further configured to send the first battery status parameter, where the first battery status parameter includes at least one of the following parameters: the discharge voltage, the discharge current, and the charging temperature.

According to a fifth aspect, a computer-readable storage medium is provided, including a computer program. When the computer program is run on a computer device, a processing unit in the computer device is enabled to perform the method in any one of the first aspect or the possible implementations of the first aspect.

According to a sixth aspect, a computer-readable storage medium is provided, including a computer program. When the computer program is run on a computer device, a processing unit in the computer device is enabled to perform the method in any one of the second aspect or the possible implementations of the second aspect.

According to a seventh aspect, a computer program product is provided, including a computer program. When the computer program is run on a computer device, a processing unit in the computer device is enabled to perform the method according to any one of the first aspect or the possible implementations of the first aspect.

According to an eighth aspect, a computer program product is provided, including a computer program. When the computer program is run on a computer device, a processing unit in the computer device is enabled to perform the method according to any one of the second aspect or the possible implementations of the second aspect.

According to a ninth aspect, a chip is provided, where the chip includes a processor and a memory, the memory is configured to store a computer program, and the processor is configured to invoke and run the computer program stored in the memory, to perform the method in any one of the first aspect or the possible implementations of the first aspect.

According to a tenth aspect, a chip is provided, where the chip includes a processor and a memory, the memory is configured to store a computer program, and the processor is configured to invoke and run the computer program stored in the memory, to perform the method in any one of the second aspect or the possible implementations of the second aspect.

According to an eleventh aspect, a chip system is provided. The chip system includes at least one processor, and when program instructions are executed in the at least one processor, the at least one processor is enabled to perform the battery detection method described above.

## BRIEF DESCRIPTION OF DRAWINGS

FIG. 1 is a schematic diagram of a battery detection method in the conventional technology;

FIG. 2 is a schematic diagram of a structure of a system architecture according to an embodiment of this application;

FIG. 3 is a schematic diagram of performing battery detection based on a convolutional neural network model according to an embodiment of this application;

FIG. 4 is a schematic diagram of a hardware structure of a chip according to an embodiment of this application;

FIG. 5 is a schematic diagram of a battery detection method according to an embodiment of this application;

FIG. 6 is a schematic diagram of another battery detection method according to an embodiment of this application;

FIG. 7 is a schematic diagram of a battery failure detection principle according to an embodiment of this application;

FIG. 8 is a schematic diagram of a system architecture according to an embodiment of this application;

FIG. 9 is a schematic diagram of interaction between modules according to an embodiment of this application;

FIG. 10 is a schematic diagram of a battery detection apparatus according to an embodiment of this application; and

FIG. 11 is a schematic diagram of another battery detection apparatus according to an embodiment of this application.

## DESCRIPTION OF EMBODIMENTS

The following describes the technical solutions of this application with reference to the accompanying drawings.

Embodiments of this application may be used for battery failure detection of an electric vehicle, or may be used for battery failure detection of various objects driven by a power battery, such as an electric bicycle.

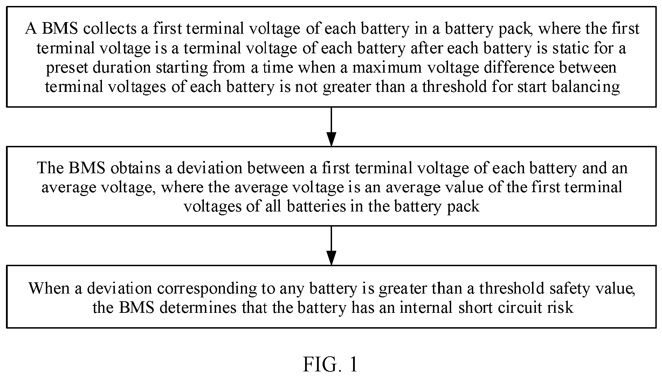

To determine a degree of an internal short circuit of a battery and reduce a loss caused by thermal runaway of the battery, the conventional technology provides a method for detecting an internal short circuit of the battery based on a voltage. As shown in FIG. 1, in the method, a battery management system (battery management system, BMS) collects a terminal voltage of each battery in a battery pack, and compares the terminal voltage with an average voltage. When a deviation between the terminal voltage and the average voltage is greater than a safety threshold, it is determined that the battery has a safety risk. In the method for detecting the battery by using the voltage in the conventional technology, a least square method is not required, and this reduces a requirement of the battery detection method for a hardware device.

However, in this method, the terminal voltage of the battery is not only related to the battery internal resistance, but also easily affected by other various factors. As a result, accuracy of this method is relatively low, and misjudgment easily occurs.

This application provides a battery detection method. In this method, a status parameter of a battery is input into a service system that includes a failure model obtained through training, to obtain a failure degree, and the failure degree is sent to a vehicle-mounted device and/or a terminal device, so that a failure risk of the battery can be accurately evaluated, and a loss caused by a battery failure can be reduced.

Because embodiments of this application relate to massive applications of a neural network, for ease of understanding, the following first describes terms and concepts related to the neural network that may be used in embodiments of this application.

(1) Neural network

The neural network may include a neuron. The neuron may be an operation unit that uses $x_s$ and an intercept of 1 as input. Output of the operation unit may be as follows:

$$h_{W,b}(x) = f(W^T x) = f\left(\sum_{s=1}^{n} W_s x_s + b\right) \ (1\text{-}1)$$

Herein, s = 1, 2, ..., n, n is a natural number greater than 1, $W_s$ represents a weight of $x_s$, both W and x are vectors, b represents a bias of the neuron, and f indicates an activation function (activation function) of the neuron, where the activation function is used for introducing a non-linear characteristic into the neural network, to convert an input signal in the neuron into an output signal. The output signal of the activation function may be used as input to a next convolutional layer, and the activation function may be a sigmoid function. The neural network is a network constituted by connecting a plurality of single neurons together. To be specific, output of a neuron may be input to another neuron. Input to each neuron may be connected to a local receptive field of a previous layer to extract a feature of the local receptive field. The local receptive field may be a region including several neurons.

## (2) Deep neural network

The deep neural network (deep neural network, DNN) is also referred to as a multi-layer neural network, and may be understood as a neural network having a plurality of hidden layers. Based on locations of different layers, neural network layers inside the DNN may be classified into three types: an input layer, a hidden layer, and an output layer. Usually, the first layer is the input layer, the last layer is the output layer, and any layer between is the hidden layer. Layers are fully connected. To be specific, any neuron at an $i^{th}$ layer is necessarily connected to any neuron at an $(i+1)^{th}$ layer.

Although the DNN seems complex, work at each layer of the DNN is actually not complex, and is simply represented as the following linear relationship expression: $\vec{y} = \alpha(W\Box\vec{x}+\vec{b})$, where $\vec{x}$ is an input vector, $\vec{y}$ is an output vector, $\vec{b}$ is an offset vector, $W$ is a weight matrix (also referred to as a coefficient), and $\alpha(\ )$ is an activation function. At each layer, the output vector $\vec{y}$ is obtained by performing such a simple operation on the input vector $\vec{x}$. Because there are a large quantity of DNN layers, there are also a large quantity of coefficients $W$ and offset vectors $\vec{b}$. Definitions of these parameters in the DNN are as follows: The coefficient $W$ is used as an example. It is assumed that in a DNN having three layers, a linear coefficient from the fourth neuron at the second layer to the second neuron at the third layer is defined as $W_{24}^{3}$. The superscript 3 indicates a layer at which the coefficient is located, and the subscript corresponds to an output third-layer index 2 and an input second-layer index 4.

In conclusion, a coefficient from a $k^{th}$ neuron at an $(L-1)^{th}$ layer to a $j^{th}$ neuron at a $L^{th}$ layer is defined as $W_{jk}^{L}$.

It should be noted that there is no parameter W at the input layer. In the deep neural network, more hidden layers make the network more capable of describing a complex case in the real world. Theoretically, a model with more parameters has higher complexity and a larger "capacity". It means that the model can complete a more complex learning task. Training of the deep neural network is a process of learning a weight matrix, and a final objective of the training is to obtain a weight matrix of all layers of a trained deep neural network (a weight matrix formed by vectors of many layers).

## (3) Convolutional neural network

The convolutional neural network (convolutional neural network, CNN) is a deep neural network with a convolutional structure. The convolutional neural network includes a feature extractor including a convolutional layer and a sub-sampling layer, and the feature extractor may be considered as a filter. The convolutional layer is a neuron layer that convolves an input signal in the convolutional neural network. At the convolutional layer of the convolutional neural network, one neuron may be connected to only a part of neurons at a neighboring layer. A convolutional layer usually includes several feature planes, and each feature plane may include some neurons arranged in a rectangle. Neurons of a same feature plane share a weight, and the shared weight herein is a convolution kernel. Sharing a weight may be understood as image information is not extracted by location. The convolution kernel may be initialized in a form of a matrix of a random size. In a training process of the convolutional neural network, an appropriate weight may be obtained for the convolution kernel through learning. In addition, sharing the weight has advantages that connections between layers of the convolutional neural network are reduced, and a risk of overfitting is reduced.

## (4) Recurrent neural network

The recurrent neural network (recurrent neural network, RNN) is used to process sequence data. In a conventional neural network model, from an input layer to a hidden layer and then to an output layer, the layers are fully connected, but nodes at each layer are not connected. This common neural network resolves many problems, but is still incompetent on many other problems. For example, to predict a next word in a sentence, a previous word usually needs to be used, because adjacent words in the sentence are not independent. A reason why the RNN, short for the recurrent neural network, is named as such is that a current output of a sequence is also related to a previous output of the sequence. A specific representation form is that the network memorizes previous information and applies the previous information to calculation of the current output. To be specific, nodes at the hidden layer are connected, and an input to the hidden layer not only includes an output of the input layer, but also includes an output of the hidden layer at a previous moment. Theoretically, the RNN can process sequence data of any length. Training of the RNN is the same as training of a conventional CNN or DNN.

A reason why the recurrent neural network is required when there is the convolutional neural network is simple. In the convolutional neural network, there is a premise that elements are independent of each other, and input and output are also independent, such as a cat and a dog. However, many elements are interconnected in the real world. For example, stocks change over time. For another example, if a person says: "I like traveling, my most favorite place is Yunnan, and I will go to ... in the future if I have a chance." Herein, people should know that the ellipsis represents "Yunnan". This is because people can make an inference from a context, but how can a machine do this? The RNN emerges. The RNN is intended to make the machine capable of memorizing like a human. Therefore, an output of the RNN needs to depend on current input information and historical memorized information.

## (5) Loss function

In a process of training the deep neural network, to make output of the deep neural network as close as possible to what expects to be predicted, a predicted value of a current network and a target value as expected may be compared, and then a weight vector of each layer of the neural network is updated based on a difference between the predicted value and the target value (certainly, there is usually an initialization process before the first update, to be specific, parameters are preconfigured for all layers of the deep neural network). For example, if the predicted value of the network is large, the weight vector is adjusted to decrease the predicted value, and adjustment is continuously performed, until the deep neural network can predict the target value as expected or a value that is very close to the target value as expected. Therefore, "how to obtain, through comparison, the difference between the predicted value and the target value" needs to be predefined. This is a loss function (loss function) or an objective function (objective function). The loss function and the objective function are important equations used to measure the difference between the predicted value and the target value. The loss function is used as an example. A larger output value (loss) of the loss function indicates a larger difference. Therefore, training of the deep neural network is a process of minimizing the loss as much as possible.

## (6) Back propagation algorithm

In a training process, a neural network may correct values of parameters in an initial neural network model by using an error back propagation (back propagation, BP) algorithm, so that a reconstruction error loss of the neural network model becomes increasingly smaller. Specifically, doing a forward pass from an input signal to an output generates an error loss, while the parameters of the neural network model are updated through back propagation of information about the error loss, to converge the error loss. The back propagation algorithm is a back propagation motion mainly dependent on the error loss, and is used for obtaining parameters of an optimal neural network model, for example, a weight matrix.

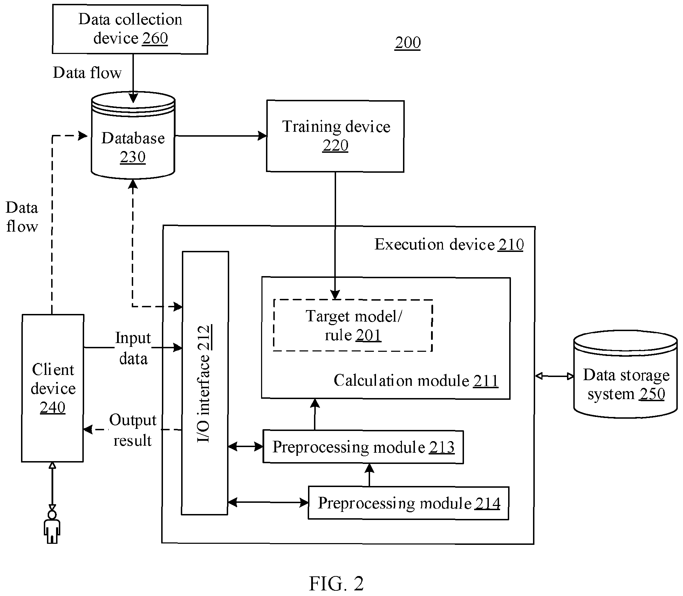

Refer to FIG. 2. An embodiment of this application provides a system architecture 200. In FIG. 2, a data collection device 260 is configured to collect training data. For the battery detection method in embodiments of this application, the training data may include a battery status parameter and a failure degree corresponding to the battery status parameter.

After collecting the training data, the data collection device 260 stores the training data in a database 230. A training device 220 obtains a target model/rule 201 through training of the training data maintained in the database 230.

The following describes the target model/rule 201 obtained by the training device 220 based on the training data. The training device 220 processes an input battery status parameter and an original failure degree, and compares an output failure degree with the original failure degree until a difference between the failure degree output by the training device 220 and the original failure degree is less than a specific threshold. In this way, training of the target model/rule 201 is completed.

The target model/rule 201 can be used to implement the battery detection method in embodiments of this application. In other words, after related preprocessing, the battery status parameter is input to the target model/rule 201, to obtain a result of the failure degree. The target model/rule 201 in embodiments of this application may be specifically a neural network. It should be noted that, during actual application, the training data maintained in the database 230 is not necessarily all collected by the data collection device 260, and may be received from another device. It should be further noted that the training device 220 may not necessarily train the target model/rule 201 completely based on the training data maintained in the database 230, or may obtain training data from a cloud or another place to perform model training. The foregoing description should not be construed as a limitation on embodiments of this application.

The target model/rule 201 obtained through training by the training device 220 may be used in different systems or devices, for example, an execution device 210 shown in FIG. 2. The execution device 210 may be a terminal, for example, a mobile phone terminal, a tablet computer, a laptop computer, an augmented reality (augmented reality, AR) AR/virtual reality (virtual reality, VR) terminal, or a vehicle-mounted terminal, or may be a server, a cloud, or the like. In FIG. 2, the execution device 210 is configured with an input/output (input/output, I/O) interface 212, to exchange data with an external device. A user may input data to the I/O interface 212 by using a client device 240. In embodiments of this application, the input data may include a battery status parameter and a failure degree corresponding to the battery status parameter.

A preprocessing module 213 and a preprocessing module 214 are configured to perform preprocessing based on input data (for example, a battery status parameter) received by the I/O interface 212. In embodiments of this application, there may be no preprocessing module 213 or preprocessing module 214 (or there may be only one preprocessing module), and a calculation module 211 is directly used to process the input data.

In a process in which the execution device 210 performs preprocessing on the input data or the calculation module 211 of the execution device 210 performs related processing such as calculation, the execution device 210 may invoke data, code, and the like in a data storage system 250 for corresponding processing, and may also store data, instructions, and the like obtained through the corresponding processing into a data storage system 250.

Finally, the I/O interface 212 returns a processing result, for example, the foregoing obtained failure degree, to the client device 240, to provide the processing result for the user.

It should be noted that the training device 220 may generate corresponding target models/rules 201 for different targets or different tasks based on different training data. The corresponding target models/rules 201 may be used to implement the targets or complete the tasks, to provide a required result for the user.

In a case shown in FIG. 2, the user may manually provide the input data and the user may provide the input data on the I/O interface 212. In another case, the client device 240 may automatically send the input data to the I/O interface 212. If it is required that the client device 240 needs to obtain authorization from the user to automatically send the input data, the user may set corresponding permission on the client device 240. The user may view, on the client device 240, a result output by the execution device 210. Specifically, the result may be presented by display, sound, action, or the like. The client device 240 may also serve as a data collection end to collect, as new sample data, the input data into the I/O interface 212 and the output result from the I/O interface 212 that are shown in the figure, and store the new sample data into the database 230. Certainly, the client device 140 may alternatively not perform collection, but the I/O interface 212 directly stores, as new sample data into the database 230, the input data into the I/O interface 212 and the output result from the I/O interface 212 that are shown in the figure.

It should be noted that FIG. 2 is merely a schematic diagram of a system architecture according to an embodiment of this application. A location relationship between devices, components, modules, and the like shown in the figure does not constitute any limitation. For example, in FIG. 2, the data storage system 250 is an external memory relative to the execution device 210, and in another case, the data storage system 250 may alternatively be disposed in the execution device 210.

As shown in FIG. 2, the target model/rule 201 is obtained through training by the training device 220. The target model/rule 201 may be a neural network in embodiments of this application. Specifically, the neural network provided in embodiments of this application may be a CNN, a deep convolutional neural network (deep convolutional neural network, DCNN), a recurrent neural network (recurrent neural network, RNN), or the like.

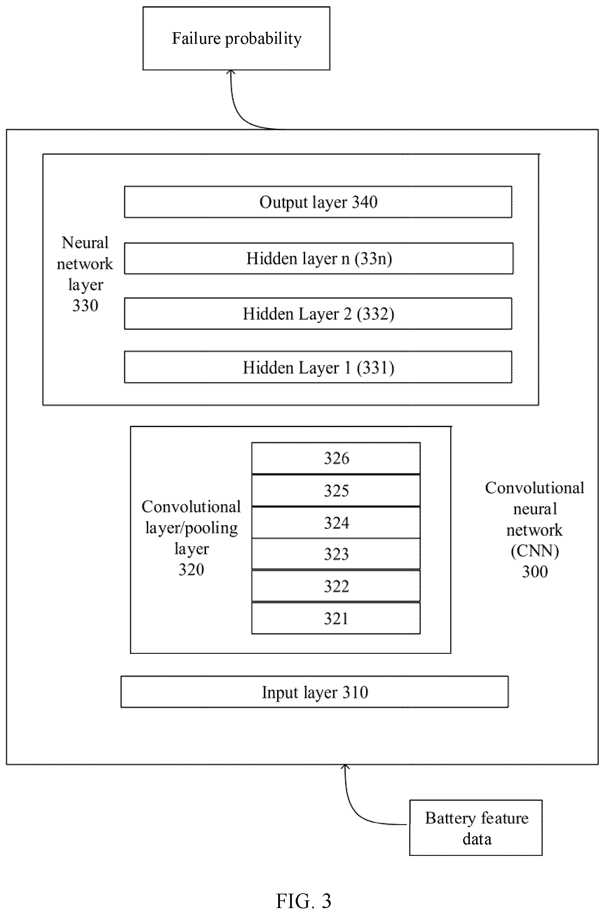

Because the CNN is a very common neural network, a structure of the CNN is described below in detail with reference to FIG. 3. As described in the foregoing description of basic concepts, the convolutional neural network is a deep neural network with a convolutional structure, and is a deep learning (deep learning) architecture. The deep learning architecture is to perform multi-level learning at different abstract levels by using a machine learning algorithm. As a deep learning architecture, the CNN is a feed-forward (feed-forward) artificial neural network, and each neuron in the feed-forward artificial neural network can respond to an image input into the feed-forward artificial neural network.

As shown in FIG. 3, a convolutional neural network (CNN) 300 may include an input layer 310, a convolutional layer/pooling layer 320 (the pooling layer is optional), and a neural network layer 330. The following describes the layers in detail.

Convolutional layer/pooling layer 320:

As shown in FIG. 3, for example, the convolutional layer/pooling layer 320 may include layers 321 to 326. For example, in an implementation, the layer 321 is a convolutional layer, the layer 322 is a pooling layer, the layer 323 is a convolutional layer, the layer 324 is a pooling layer, the layer 325 is a convolutional layer, and the layer 326 is a pooling layer. In another implementation, the layer 321 and the layer 322 are convolutional layers, the layer 323 is a pooling layer, the layer 324 and the layer 325 are convolutional layers, and the layer 326 is a pooling layer. To be specific, an output of a convolutional layer may be used as an input to a subsequent pooling layer, or may be used as an input to another convolutional layer to continue a convolution operation.

The following uses the convolutional layer 321 as an example to describe an internal working principle of one convolutional layer.

The convolutional layer 321 may include a plurality of convolution operators. The convolution operator is also referred to as a kernel. In battery detection, the convolution operator functions as a filter that extracts specific information from information such as an input battery status parameter. The convolution operator may essentially be a weight matrix, and the weight matrix is usually predefined. In a process of performing a convolution operation on a battery status parameter, the weight matrix usually processes data one by one in the input battery status parameter, to extract a specific feature from the battery status parameter. A size of the weight matrix should be related to a value of the battery status parameter. It should be noted that a depth dimension (depth dimension) of the weight matrix is the same as a depth dimension of the input battery status parameter. During a convolution operation, the weight matrix extends to an entire depth of the input battery status parameter. Therefore, a convolutional output of a single depth dimension is generated through convolution with a single weight matrix. However, in most cases, a single weight matrix is not used, but a plurality of weight matrices with a same size (rows × columns), namely, a plurality of matrices of same dimensions, are applied. Outputs of weight matrices are stacked to form a depth dimension of a convolutional battery status parameter. The dimension herein may be understood as being determined based on the foregoing "plurality". Different weight matrices may be used to extract different features from the battery status parameter. For example, one weight matrix is used to extract discharge voltage data, another weight matrix is used to extract discharge current data, and still another weight matrix is used to extract charging temperature data.

Weight values in these weight matrices need to be obtained through a lot of training during actual application. Each weight matrix formed by using the weight values obtained through training may be used to extract information from an input battery status parameter, to enable the convolutional neural network 300 to perform correct prediction.

When the convolutional neural network 300 has a plurality of convolutional layers, a relatively large quantity of general features are usually extracted at an initial convolutional layer (for example, 321). The general feature may also be referred to as a low-level feature. As the depth of the convolutional neural network 300 increases, a feature extracted at a subsequent convolutional layer (for example, 326) becomes more complex, for example, a high-level semantic feature. A feature with higher semantics is more applicable to a to-be-resolved problem.

Pooling layer:

Because a quantity of training parameters usually needs to be reduced, a pooling layer usually needs to be periodically introduced after a convolutional layer. To be specific, for the layers 321 to 326 in the layer 320 shown in FIG. 3, one convolutional layer may be followed by one pooling layer, or a plurality of convolutional layers may be followed by one or more pooling layers. In a battery detection process, a unique purpose of the pooling layer is to reduce a space size of the battery status parameter.

Neural network layer 330:

After processing performed at the convolutional layer/pooling layer 320, the convolutional neural network 300 is not ready to output required output information. As described above, at the convolutional layer/pooling layer 320, only features are extracted, and parameters resulting from an input status parameter are reduced. However, to generate final output information (required class information or other related information), the convolutional neural network 300 needs to use the neural network layer 330 to generate an output of one required class or outputs of a group of required classes. Therefore, the neural network layer 330 may include a plurality of hidden layers (331 and 332 to 33n shown in FIG. 3) and an output layer 340. Parameters included in the plurality of hidden layers may be obtained through pre-training of related training data of a specific task type.

At the neural network layer 330, the plurality of hidden layers are followed by the output layer 340, namely, the last layer of the entire convolutional neural network 300. The output layer 340 has a loss function similar to a categorical cross entropy, and the loss function is specifically used to calculate a prediction error. Once forward propagation (for example, propagation in a direction from 310 to 340 in FIG. 3) of the entire convolutional neural network 300 is completed, back propagation (for example, propagation in a direction from 340 to 310 in FIG. 3) is started to update a weight value and a bias of each layer mentioned above, to reduce a loss of the convolutional neural network 300 and an error between a result output by the convolutional neural network 300 through the output layer and an ideal result.

It should be noted that the convolutional neural network 300 shown in FIG. 3 is used only as an example of a convolutional neural network. In a specific application, the convolutional neural network may alternatively exist in a form of another network model.

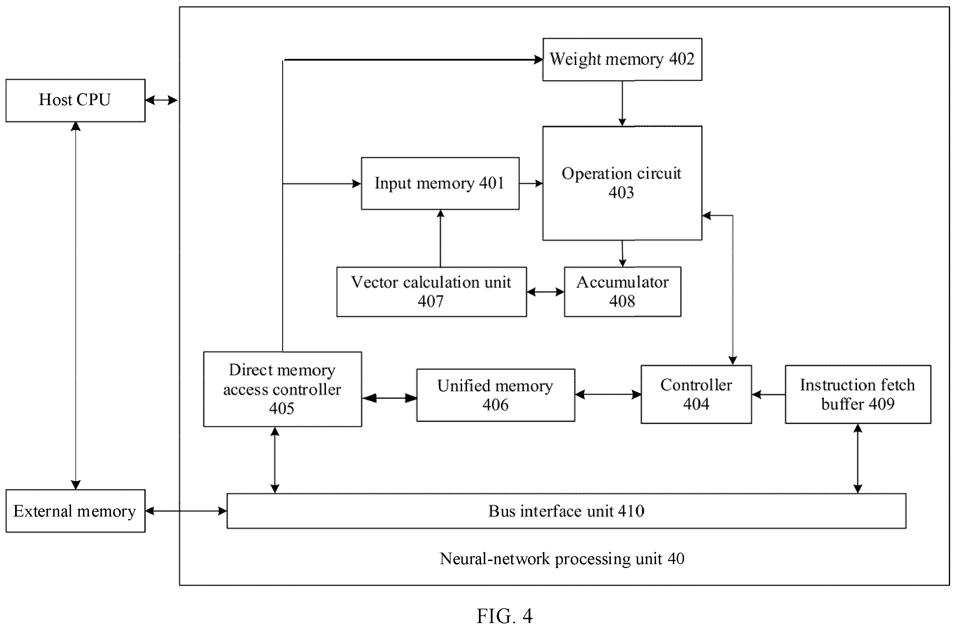

FIG. 4 shows a hardware structure of a chip according to an embodiment of this application, and the chip includes a neural-network processing unit 40. The chip may be disposed in the execution device 210 shown in FIG. 2, and is configured to complete calculation work of the calculation module 211. The chip may alternatively be disposed in the training device 220 shown in FIG. 2, and is configured to complete training work of the training device 220 and output the target model/rule 201. All algorithms of the layers in the convolutional neural network shown in FIG. 3 may be implemented in the chip shown in FIG. 4.

The neural-network processing unit NPU 40 serves as a coprocessor, and may be disposed on a host central processing unit (central processing unit, CPU) (host CPU). The host CPU assigns a task. A core part of the NPU is an operation circuit 403, and a controller 404 controls the operation circuit 403 to extract data in a memory (a weight memory or an input memory) and perform an operation.

In some implementations, the operation circuit 403 includes a plurality of process engines (process engines, PEs). In some implementations, the operation circuit 403 is a two-dimensional systolic array. The operation circuit 403 may alternatively be a one-dimensional systolic array or another electronic circuit capable of performing mathematical operations such as multiplication and addition. In some implementations, the operation circuit 403 is a general-purpose matrix processor.

For example, it is assumed that there is an input matrix A, a weight matrix B, and an output matrix C. The input matrix A in this embodiment of this application may be a matrix of battery status parameters, and the output matrix in this embodiment of this application may be a matrix of failure degrees. The operation circuit fetches corresponding data of the matrix B from a weight memory 402, and buffers the data on each PE in the operation circuit. The operation circuit fetches data of the matrix A from an input memory 401, to perform a matrix operation with the matrix B, and stores an obtained partial result or an obtained final result of the matrice into an accumulator (accumulator) 408.

A vector calculation unit 407 may perform further processing on the output of the operation circuit, for example, vector multiplication, vector addition, exponential operation, logarithmic operation, and value comparison. For example, the vector calculation unit 407 may be configured to perform network calculation, such as pooling (pooling), batch normalization (batch normalization), or local response normalization (local response normalization) at a non-convolutional/non-FC layer in a neural network.

In some implementations, the vector calculation unit 407 can store a processed output vector in a unified memory 406. For example, the vector calculation unit 407 may apply a non-linear function to the output of the operation circuit 403, for example, a vector of an accumulated value, to generate an activation value. In some implementations, the vector calculation unit 407 generates a normalized value, a combined value, or both. In some implementations, the processed output vector can be used as an activation input to the operation circuit 403, for example, for use in subsequent layers in the neural network.

The unified memory 406 is configured to store input data and output data.

For weight data, a direct memory access controller (direct memory access controller, DMAC) 405 is used to transfer input data in an external memory to the input memory 401 and/or the unified memory 406, store weight data in the external memory into the weight memory 402, and store the data in the unified memory 406 into the external memory.

A bus interface unit (bus interface unit, BIU) 410 is configured to implement interaction between the host CPU, the DMAC, and an instruction fetch buffer 409 by using a bus.

The instruction fetch buffer (instruction fetch buffer) 409 connected to the controller 404 is configured to store instructions used by the controller 404.

The controller 404 is configured to invoke the instructions buffered in the instruction fetch buffer 409, to control a working process of an operation accelerator.

Entry: Data herein may be described as description data according to an actual invention, for example, a detected vehicle speed, a distance to an obstacle, and the like.

Usually, the unified memory 406, the input memory 401, the weight memory 402, and the instruction fetch buffer 409 each are an on-chip (On-Chip) memory. The external memory is a memory outside the NPU. The external memory may be a double data rate synchronous dynamic random access memory (double data rate synchronous dynamic random access memory, DDR SDRAM), a high bandwidth memory (high bandwidth memory, HBM), or another readable and writable memory.

Operations at various layers in the convolutional neural network shown in FIG. 3 may be performed by the operation circuit 403 or the vector calculation unit 407.

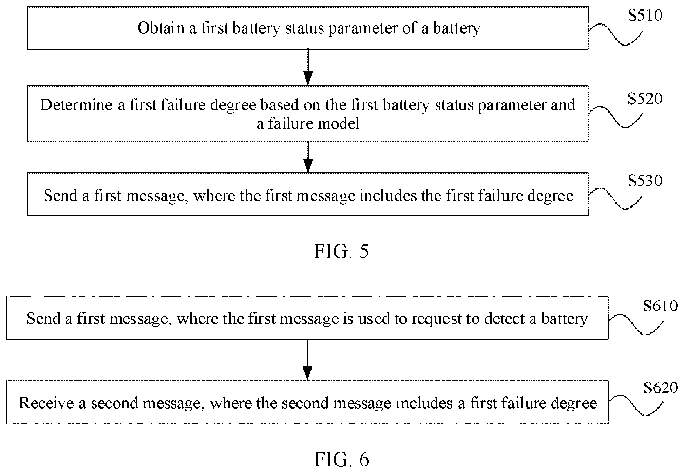

FIG. 5 is a schematic diagram of a battery detection method according to an embodiment of this application. As shown in FIG. 5, the method includes steps S510 to S530. The following describes the three steps in detail.

S510: A service system obtains a first battery status parameter of a battery.

Optionally, the service system may request, by sending a message to a vehicle-mounted system, the vehicle-mounted system to send the first battery status parameter of the battery, or the service system may invoke previously stored battery status data from a storage module.

It should be understood that the vehicle-mounted system in this embodiment of this application may obtain a status parameter of a vehicle battery. The battery status parameter may include a driving mileage, a current battery SOC, a rechargeable battery temperature, a time, a discharge voltage, a discharge current, a battery model, and the like.

S520: The service system determines a first failure degree based on the first battery status parameter and a failure model.

It should be understood that, after obtaining the first failure degree, the service system may display a detection result on the device, where the display form may be voice, text, or the like.

In an embodiment, the first failure degree indicates a failure degree of a current battery status, the failure model is obtained through training based on a second battery status parameter and a second failure degree, the second failure degree is a detected failure degree that is of a battery with a same specification and that corresponds to the second battery status parameter, and the battery status parameter includes at least one of the following parameters: a discharge voltage, a discharge current, and a charging temperature.

It should be understood that a battery failure is a gradual process. For example, the battery failure may be divided into three phases: early internal short circuit, middle internal short circuit, and later internal short circuit (thermal runaway). In each phase, electrical features (such as voltage and current) and a thermal feature (temperature) of the battery are different. For example, in the later internal short circuit, the voltage is lost and heat is generated sharply. For lithium-ion batteries, the three phases can be divided based on whether there is obvious self-generated heat and whether a separator failure temperature is reached. The three phases correspond to different failure degrees (such as 30% and 80%). Division of the battery failure phases is not limited in this application.

Optionally, the second battery status parameter may be obtained test data of a real battery of a same specification. In this case, based on battery failure degrees corresponding to different phases, the second failure degree may be a failure degree that corresponds to the second battery status parameter and that is actually recorded when the battery works normally, or may be a failure degree that is actually recorded when the battery fails. Alternatively, the test data may be test data obtained after a working condition simulation test is performed on a vehicle battery in a lab environment. For example, a discharge test is performed by setting a discharge temperature and a load of the battery, and test values such as a discharge voltage, a temperature, and an internal resistance of the battery are recorded. In this case, the second failure degree may be a failure degree recorded when the battery works normally in the simulation test, or may be failure degree data recorded when the battery fails in the simulation test.

The failure degree of the battery is obtained by inputting the battery status parameter into the failure model, so that a battery failure risk can be accurately evaluated, to reduce personal injuries and property losses caused by thermal runaway of the battery.

In an embodiment, the failure model is obtained through algorithm training, and the process includes: inputting the second battery status parameter into an original model to obtain a third failure degree; adjusting a parameter of the original model, so that a deviation between the third failure degree and the second failure degree falls within a preset range; and using the original model that goes through the adjustment as the failure model. Optionally, the foregoing failure model may be obtained from the system shown in FIG. 2.

It should be understood that, the third failure degree obtained by using the original model is compared with the second failure degree that is of the battery and that is obtained through a real test, and the deviation between the third failure degree and the second failure degree is controlled within the preset range, so that a failure model that is more consistent with a real situation can be obtained, and accuracy of battery failure detection can be improved.

Optionally, the failure model in this embodiment of this application may be obtained by a remote service through training, or may be obtained from another device.

Optionally, in addition to the parameters included in the first battery status parameter, the service system may further detect the failure degree of the battery based on the battery internal resistance. Specifically, the determining the first failure degree based on the first battery status parameter and the failure model specifically includes: determining the battery internal resistance based on at least one parameter of the discharge voltage, the discharge current, and the charging temperature that are included in the first battery status parameter, where the battery internal resistance is used to determine the first failure degree.

It should be understood that the battery internal resistance may be obtained by using a filtering method. The method can be achieved by the conventional technology, and details are not described in this embodiment of this application.

Optionally, the service system in this embodiment of this application may detect the battery after receiving the request message sent by a vehicle-mounted device and/or a terminal device. Specifically, before the determining the first failure degree based on the first battery status parameter and the failure model, the method further includes: receiving a third message, where the third message is used to request to detect the battery. Optionally, the service system may obtain the third message before obtaining the first battery status parameter, or may obtain the third message before the service system determines the failure degree based on the status parameter and the failure model.

The battery is detected after the request message sent by the vehicle-mounted device and/or the terminal device is received, so that a requirement of a user for detecting the battery at any time can be met, and user experience can be improved.

It should be understood that the service system in this embodiment of this application may be disposed inside the vehicle. Alternatively, when the vehicle or another object using a power battery cannot meet a hardware requirement, optionally, the service system in this embodiment of this application may be a remote service system independent of the vehicle or the another object.

S530: The service system sends a first message, where the first message includes the first failure degree.

In an embodiment, after obtaining the first failure degree, the service system may send the first failure degree. Optionally, the service system may send the first failure degree to the vehicle-mounted device of a vehicle to which the service system belongs, or may send the first failure degree to the terminal device (for example, a mobile phone or an application APP on the terminal device), or may send the message to a manufacturer service center, and share the message with another application module on a remote server.

In an embodiment, the service system may further send a reminder message. Specifically, when the first failure degree is greater than or equal to a preset first threshold, the service system may send a second message, where the second message is used to indicate that the battery has a failure risk. Optionally, the second message may include a warning message, for example, reminding the user to repair or replace a battery, or include a message used to indicate the vehicle to take a coercive measure, for example, forcing the vehicle to decelerate or stop.

The detection result is sent to the vehicle-mounted device, the terminal device, the mobile app, or the like, so that the user can determine a current battery failure status. The user can perform corresponding processing, for example, repair on the vehicle battery based on a requirement of the user. In addition, an alarm is sent when the failure degree exceeds a threshold, so that personal injuries and property safety of the user can be further ensured.

Optionally, the service system may also perform internal short circuit detection on the battery based on a preset time. Specifically, the sending a first message specifically includes: sending the first message within a first preset time after the first battery status parameter is obtained.

A preset time is set for the service system, so that the service system can send periodic battery detection information to the vehicle-mounted device or the terminal device, to improve user experience and reduce a loss caused by a battery failure.

FIG. 6 is a schematic diagram of another battery detection method according to an embodiment of this application. As shown in FIG. 6, the method includes steps S610 and S620. The following describes the two steps in detail.

S610: Send a first message, where the first message is used to request to detect a battery.

S620: Receive a second message, where the second message includes a first failure degree.

In an embodiment, the first failure degree is used to indicate a failure degree that is of the battery and that corresponds to a first battery status parameter, the failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature.

Optionally, the first message may be sent by a vehicle-mounted device, a terminal device, a mobile APP in the terminal device, or the like. This is not limited in this embodiment of this application.

In an embodiment, the vehicle-mounted device or the terminal device or the application APP may receive a reminder message. Specifically, the vehicle-mounted device or the terminal device or the application APP receives a third message, where the third message is used to indicate that the battery has a failure risk, and the third message is sent by a service system or a terminal device when the first failure degree is greater than or equal to a first threshold.

Optionally, when the first message is sent by the vehicle-mounted device, the third message may be used to indicate the vehicle-mounted device to take a coercive measure, like forced deceleration or forced parking, or the third message may be further used to remind the user to repair or replace the battery as soon as possible.

Optionally, the vehicle-mounted device or the terminal device or the application APP may display the second message or the third message, for example, may display the second message or the third message on a display screen or by voice. Specifically, the second message and/or the third message are/is displayed by using a display apparatus.

Optionally, before requesting the service system to perform battery detection, the vehicle-mounted device may send the battery status parameter to the service system. Specifically, the vehicle-mounted device sends the first battery status parameter, where the first battery status parameter includes at least one of the following parameters: the discharge voltage, the discharge current, and the charging temperature.

Other steps are the same as those in FIG. 5, and details are not described again in this embodiment of this application.

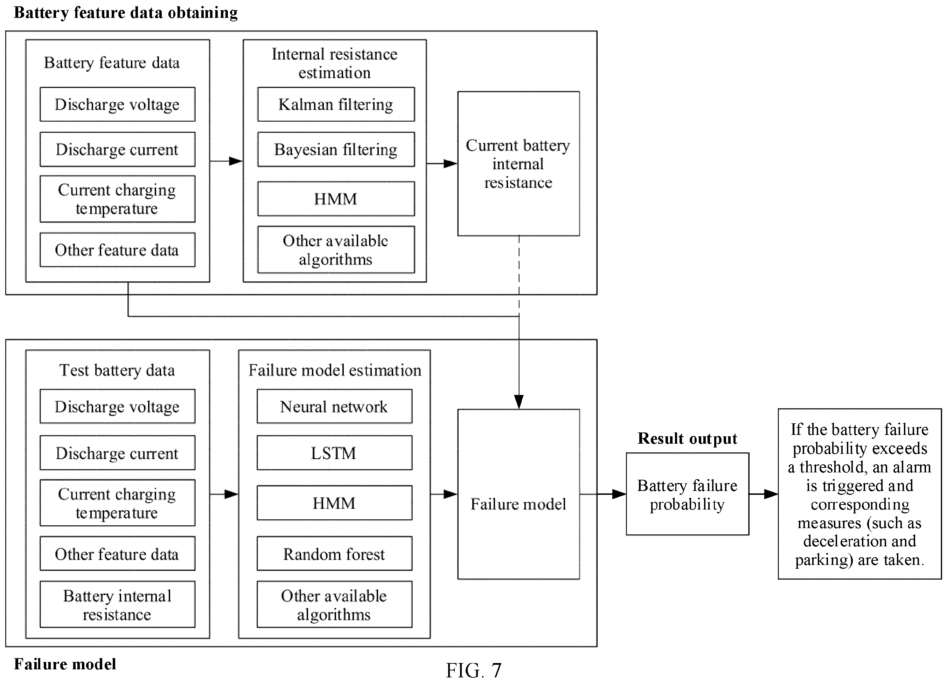

FIG. 7 is a schematic diagram of a battery failure detection principle according to an embodiment of this application. As shown in FIG. 7, the schematic diagram mainly includes a battery status parameter obtaining part, a failure model part, and a result output part.

The battery status parameter obtaining part may include a battery status parameter and internal resistance estimation. A battery status parameter may include a discharge voltage, a discharge current, a current charging temperature, and another status parameter. The battery status parameter is sent by a vehicle-mounted system to a service system. The service system may obtain the status parameter by sending a request to the vehicle-mounted system, or optionally, the service system may invoke a stored battery status parameter from a storage module. The service system may input these status parameters to a failure model for battery detection. The battery status parameter input into the failure model further includes a battery internal resistance. Specifically, the service system obtains the current battery internal resistance according to a status estimation algorithm based on at least one of the foregoing battery status parameters. The status estimation algorithm may be a Kalman filtering, a Bayesian filtering, a hidden Markov model (hidden Markov model, HMM), or another algorithm to estimate the battery internal resistance. A method for obtaining a battery internal resistance value according to a status estimation algorithm can be achieved by the conventional technology, and details are not described in this application.

The failure model part may include: obtaining test battery data. The test battery data herein may alternatively be the second battery status parameter in the foregoing embodiments of this application. The test battery data may be obtained test data of a real battery, or the test data may be test data obtained after a working condition simulation test is performed on a vehicle battery in a lab environment. For example, a discharge test is performed by setting a discharge temperature and a load of the battery, and test values such as the discharge voltage, the temperature, and the battery internal resistance are recorded. The failure model part may further include failure model estimation. Specifically, an algorithm module of the service system may build, based on the foregoing test data, a failure model about the battery discharging status parameter according to algorithms such as a neural network, a long short-term memory (long short-term memory, LSTM), a random forest, and an HMM. For example, the failure model may be obtained by using the neural network shown in FIG. 2 or FIG. 3, and a battery failure degree threshold is obtained.

Then, the service system may output a battery detection result based on the battery status parameter and the failure model. Further, an alarm message may be sent based on the failure degree threshold.

A battery failure degree is obtained by using a plurality of real-time battery status parameters including the battery internal resistance value and based on the failure model obtained through training, so that a battery failure risk can be accurately evaluated, and a loss caused by a battery failure can be reduced.

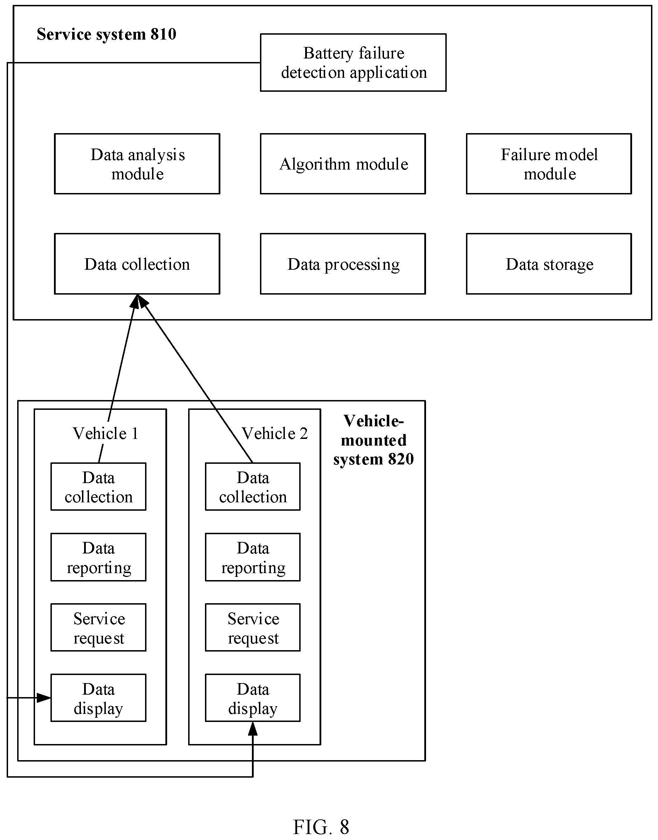

FIG. 8 is a schematic diagram of a system architecture according to an embodiment of this application. As shown in FIG. 8, the system architecture in this embodiment of this application may include a service system 810 and a vehicle-mounted system 820.

The vehicle-mounted system 820 may collect battery-related data (including but not limited to a driving mileage, a current battery SOC, a battery temperature, a time, a discharge voltage, a discharge current, a battery model, and the like), and send the data to the service system over a specified protocol. The vehicle-mounted system 820 may include a data collection module, a data reporting module, a service request module, and a data display module.

The service system 810 may include three layers. A first layer may include a data collection module, a data processing module, and a data storage module. A second layer may include a data analysis module, an algorithm module, and a failure model module. A third layer may include a battery failure detection application module.

The service system 810 may have the following functions: After receiving the battery data, the service system parses a data packet, and then performs classified storage based on a vehicle identification number or another identifier. Based on the test battery data, the service system may generate a related failure model by using the algorithm module and based on the algorithm, and store the model in the failure model module. The service system may receive a detection request sent by a vehicle-mounted system, a terminal device, or another application, for example, a mobile phone application APP, and perform internal short circuit detection on a specified battery. The service system sends a detection result to a related vehicle-mounted system, terminal device (such as a mobile phone or a mobile APP), or another application service for data display. Optionally, the data may be displayed by voice, text, or the like. Optionally, the service system 810 may be disposed in a vehicle, or may be a remote service system independent of the vehicle. Disposing the service system in the remote service system independent of the vehicle can overcome a problem that a hardware requirement for the service system is relatively high.

The battery failure detection application module may further include an information exchange module and an internal short circuit detection module.

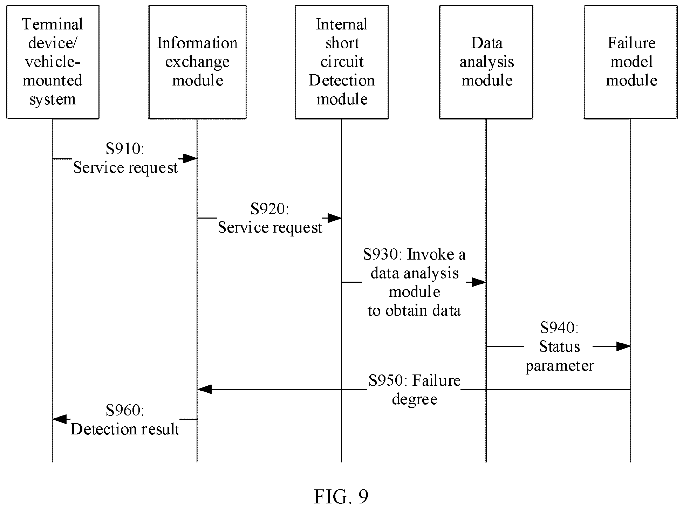

FIG. 9 is a schematic diagram of interaction between modules according to an embodiment of this application. As shown in FIG. 9, S910: The information exchange module receives a battery detection service request sent by a vehicle or a terminal device. S920: The internal short circuit detection module receives the service request.

S930: The internal short circuit detection module receives detection indication from the information exchange module, and invokes the data analysis module to obtain the battery data. The internal short circuit detection module may configure a battery discharge feature type that needs to be detected, for example, discharge voltage data, discharge current data, or charging temperature data. The data analysis module obtains a current battery status parameter. Optionally, the service system may send a message to obtain latest battery data, or the service system may obtain stored battery status data from the storage module. It should be understood that the vehicle battery data stored in the storage module may include a plurality of types of data, but only several types of specific data may be required for internal short circuit detection. In this case, the data analysis module may extract a status parameter based on a battery status parameter type configured by the internal short circuit detection module, and extract only a status parameter required for battery detection. Optionally, when the service system is independent of the vehicle-mounted system, the service system may receive service requests of a plurality of objects. In this case, the data analysis module may first identify a vehicle that needs to be detected, and then obtain a battery status parameter of the battery of the vehicle. Optionally, when the detected battery data includes the battery internal resistance, the data storage module may further obtain the battery internal resistance based on the obtained battery data, for example, at least one of the discharge voltage data, the discharge current data, and the discharge temperature data, by using the status estimation algorithm.

S940: The failure model module receives the status parameter obtained by the data analysis module through processing. S950: The failure model module performs detection based on the battery status parameter, obtains a battery failure degree in a current status, and returns the battery failure degree to the information exchange module. S960: The information exchange module returns the detection result to the vehicle, the terminal device, or the mobile phone APP. Optionally, when the failure degree in the detection result exceeds the degree threshold, the information exchange module may further send an alarm message, where the alarm message may include a repair prompt, a deceleration prompt, a parking prompt, or the like. Optionally, the information exchange module may further send the failure result to another related service for use, for example, a manufacturer service center.

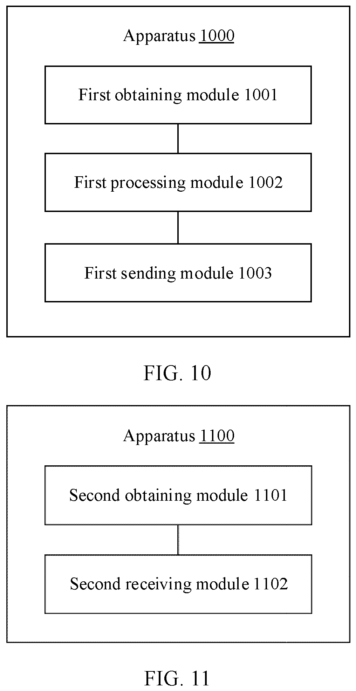

FIG. 10 is a schematic diagram of a battery detection apparatus according to an embodiment of this application. As shown in FIG. 10, an apparatus 1000 includes a first obtaining module 1001, a first processing module 1002, and a first sending module 1003. The apparatus 1000 may be configured to implement a battery detection function in any one of the foregoing method embodiments. For example, the apparatus 1000 may be a service system. The network element or network function may be a network element in a hardware device, may be a software function running on dedicated hardware, or may be a virtualized function instantiated on a platform (for example, a cloud platform).

The apparatus 1000 may be used as a service system to detect a battery, and perform the steps performed by the service system in the foregoing method embodiments. The first obtaining module 1001 and the first sending module 1003 may be configured to support the apparatus 1000 in performing communication, for example, performing sending/receiving actions in FIG. 5 and FIG. 6 as performed by the service system. The first processing module 1002 may be configured to support the apparatus 1000 in performing a processing action in the foregoing method, for example, performing a processing action in FIG. 5 or FIG. 6 as performed by the service system. Specifically, refer to the following descriptions.

The first obtaining module 1001 is configured to obtain a first battery status parameter of a battery. The first processing module 1002 is configured to determine a first failure degree based on the first battery status parameter and a failure model, where the first failure degree is used to indicate a failure degree that is of the battery and that corresponds to the first battery status parameter, the failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature. The first sending module 1003 is configured to send a first message, where the first message includes the first failure degree.

Optionally, the processing module is specifically configured to: determine a battery internal resistance based on at least one parameter of the discharge voltage, the discharge current, and the charging temperature that are included in the first battery status parameter, where the battery internal resistance is used to determine the first failure degree.

Optionally, the first sending module is further configured to: send a second message when the first failure degree is greater than or equal to a preset first threshold, where the second message is used to indicate that the battery has a failure risk.

Optionally, the apparatus further includes a first receiving module, configured to receive a third message, where the third message is used to request to detect the battery.

Optionally, the first sending module is specifically configured to send the first message within a first preset time after the first battery status parameter is obtained.

Optionally, the first processing module is further configured to: input the second battery status parameter into an original model, to obtain a third failure degree; adjust a parameter of the original model, so that a deviation between the third failure degree and the second failure degree falls within a preset range; and use the original model that goes through the adjustment as the failure model.

FIG. 11 is a schematic diagram of a battery detection apparatus according to an embodiment of this application. As shown in FIG. 11, an apparatus 1100 includes a second sending module 1101 and a second receiving module 1102. The apparatus 1100 may be configured to implement a battery detection function in any one of the foregoing method embodiments.

The apparatus 1100 may be used as a service system to detect a battery, and perform the steps performed by the vehicle-mounted device in the foregoing method embodiments. The second sending module 1101 and the second receiving module 1102 may be configured to support the apparatus 1100 in performing communication, for example, performing sending/receiving actions in FIG. 5 and FIG. 6 as performed by the vehicle-mounted device. Optionally, the apparatus 1100 may further include a second processing module 1103. The processing module 1103 may be configured to support the apparatus 1100 in performing a processing action in the foregoing method, for example, performing a processing action in FIG. 5 and FIG. 6 as performed by the vehicle-mounted device. Specifically, refer to the following descriptions.

The second sending module 1101 is configured to send a first message, where the first message is used to request the service system to detect a battery. The second receiving module 1102 is configured to receive a second message, where the second message includes a first failure degree, the first failure degree is used to indicate a failure degree that is of the battery and that corresponds to a first battery status parameter, a failure model is obtained through training based on a second battery status parameter and a second failure degree, the second failure degree is a detected failure degree that is of a battery with a same specification and that corresponds to the second battery status parameter, and a battery status parameter includes at least one of the following parameters: a discharge voltage, a discharge current, and a charging temperature.

Optionally, the second receiving module is further configured to receive a third message, where the third message is used to indicate that the battery has a failure risk, and the third message is sent by a service system or a terminal device when the first failure degree is greater than or equal to a first threshold.

Optionally, the apparatus further includes a second processing module, configured to take a coercive action based on the third message.

Optionally, the apparatus further includes a display module, configured to display the second message and/or the third message by using a display apparatus.

Optionally, the second sending module is further configured to send the first battery status parameter, where the first battery status parameter includes at least one of the following parameters: the discharge voltage, the discharge current, and the charging temperature.

A person of ordinary skill in the art may be aware that, the units and algorithm steps in the examples described with reference to embodiments disclosed in this specification may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the foregoing apparatus embodiments are merely examples. For example, division of the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected based on actual requirements to achieve the objective of the solutions of embodiments.

In addition, functional units in embodiments of this application may be integrated into one processing unit, each of the units may exist alone physically, or two or more units are integrated into one unit.

When the functions are implemented in a form of a software function unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or a compact disc.

## Claims

1. A battery detection method, wherein the method comprises:

   obtaining (S510) a first battery status parameter of a battery;
   determining (S520) a first failure degree based on the first battery status parameter and a failure model, wherein the first failure degree is used to indicate a failure degree that is of the battery and that corresponds to the first battery status parameter, the failure model is obtained through training based on a second battery status parameter and a second failure degree, the second failure degree is a detected failure degree that is of a battery with a same specification and that corresponds to the second battery status parameter, and a battery status parameter comprises at least one of the following parameters:

   a discharge voltage, a discharge current, and a charging temperature; and
   sending (S530) a first message, wherein the first message comprises the first failure degree;
   **characterized in that**
   the determining (S520) a first failure degree based on the first battery status parameter and a failure model specifically comprises:

   determining a battery internal resistance based on at least one parameter of the discharge voltage, the discharge current, and the charging temperature that are comprised in the first battery status parameter, wherein the battery internal resistance is used to determine the first failure degree; and
wherein the battery internal resistance is estimated according to a status estimation algorithm, and the battery internal resistance as well as the first battery status parameter are input into the failure model to determine the first failure degree.

2. The method according to claim 1, wherein the method further comprises:
sending a second message when the first failure degree is greater than or equal to a preset first threshold, wherein the second message is used to indicate that the battery has a failure risk.

3. The method according to any one of claims 1 to 2, wherein before the determining a first failure degree based on the first battery status parameter and a failure model, the method further comprises:
receiving a third message, wherein the third message is used to request to detect the battery.

4. The method according to any one of claims 1 to 3, wherein the sending a first message specifically comprises:
sending the first message within a first preset time after the first battery status parameter is obtained.

5. The method according to any one of claims 1 to 4, wherein the method further comprises:

inputting the second battery status parameter into an original model, to obtain a third failure degree;
adjusting a parameter of the original model, so that a deviation between the third failure degree and the second failure degree falls within a preset range; and
using the original model that goes through the adjustment as the failure model.

6. A battery detection apparatus, configured to perform the method according to any one of claims 1 to 5.

7. A computer program product comprising instructions which, when the program is executed by a computer, cause the computer to perform the method according to any one of claims 1 to 5.

8. A computer-readable storage medium comprising instructions which, when executed by a computer, cause the computer to carry out the method according to any one of claims 1 to 5.

**Patentansprüche**

1. Batteriedetektionsverfahren, wobei das Verfahren Folgendes umfasst:

Erlangen (S510) eines ersten Batteriestatusparameters einer Batterie;
Bestimmen (S520) eines ersten Ausfallgrades auf der Grundlage des ersten Batteriestatusparameters und eines Ausfallmodells, wobei der erste Ausfallgrad verwendet wird, um einen Ausfallgrad anzuzeigen, der zu der Batterie gehört und der dem ersten Batteriestatusparameter entspricht, das Ausfallmodell durch Training auf der Grundlage eines zweiten Batteriestatusparameters und eines zweiten Ausfallgrades erlangt wird, der zweite Ausfallgrad ein detektierter Ausfallgrad ist, der zu einer Batterie mit einer gleichen Spezifikation gehört und der dem zweiten Batteriestatusparameter entspricht, und ein Batteriestatusparameter mindestens einen der folgenden Parameter umfasst:

eine Entladespannung, einen Entladestrom und eine Ladetemperatur; und
Senden (S530) einer ersten Nachricht, wobei die erste Nachricht den ersten Ausfallgrad umfasst;
**dadurch gekennzeichnet, dass**
das Bestimmen (S520) eines ersten Ausfallgrades auf der Grundlage des ersten Batteriestatusparameters und eines Ausfallmodells insbesondere Folgendes umfasst:

Bestimmen eines Batterieinnenwiderstands auf der Grundlage von mindestens einem Parameter der Entladespannung, des Entladestroms und der Ladetemperatur, die in dem ersten Batteriestatusparameter umfasst sind, wobei der Batterieinnenwiderstand verwendet wird, um den ersten Ausfallgrad zu bestimmen; und
wobei der Batterieinnenwiderstand gemäß einem Statusschätzungsalgorithmus geschätzt wird und der Batterieinnenwiderstand sowie der erste Batteriestatusparameter in das Ausfallmodell eingegeben werden, um den ersten Ausfallgrad zu bestimmen.

2. Verfahren nach Anspruch 1, wobei das Verfahren ferner Folgendes umfasst:
Senden einer zweiten Nachricht, wenn der erste Ausfallgrad größer als oder gleich einem voreingestellten ersten Schwellenwert ist, wobei die zweite Nachricht verwendet wird, um anzuzeigen, dass die Batterie ein Ausfallrisiko aufweist.

**3.** Verfahren nach einem der Ansprüche 1 bis 2, wobei das Verfahren vor dem Bestimmen eines ersten Ausfallgrades auf der Grundlage des ersten Batteriestatusparameters und eines Ausfallmodells ferner Folgendes umfasst:
Empfangen einer dritten Nachricht, wobei die dritte Nachricht verwendet wird, um die Batterie zu detektieren.

**4.** Verfahren nach einem der Ansprüche 1 bis 3, wobei das Senden einer ersten Nachricht insbesondere Folgendes umfasst:
Senden der ersten Nachricht innerhalb einer ersten voreingestellten Zeit, nachdem der erste Batteriestatusparameter erlangt worden ist.

**5.** Verfahren nach einem der Ansprüche 1 bis 4, wobei das Verfahren ferner Folgendes umfasst:

Eingeben des zweiten Batteriestatusparameters in ein ursprüngliches Modell, um einen dritten Ausfallgrad zu erlangen;
Anpassen eines Parameters des ursprünglichen Modells, sodass eine Abweichung zwischen dem dritten Ausfallgrad und dem zweiten Ausfallgrad innerhalb eines voreingestellten Bereichs liegt; und Verwenden des ursprünglichen Modells, das die Anpassung durchläuft, als das Ausfallmodell.

**6.** Batteriedetektionsvorrichtung, die dazu konfiguriert ist, das Verfahren nach einem der Ansprüche 1 bis 5 durchzuführen.

**7.** Computerprogrammprodukt, umfassend Anweisungen, die, wenn das Programm durch einen Computer ausgeführt wird, den Computer dazu veranlassen, das Verfahren nach einem der Ansprüche 1 bis 5 durchzuführen.

**8.** Computerlesbares Speichermedium, umfassend Anweisungen, die, wenn sie durch einen Computer ausgeführt werden, den Computer dazu veranlassen, das Verfahren nach einem der Ansprüche 1 bis 5 auszuführen.

**Revendications**

**1.** Procédé de détection de batterie, dans lequel le procédé comprend :

l'obtention (S510) d'un premier paramètre d'état de batterie d'une batterie ;
la détermination (S520) d'un premier degré de défaillance sur la base du premier paramètre d'état de la batterie et d'un modèle de défaillance, dans lequel le premier degré de défaillance est utilisé pour indiquer un degré de défaillance qui est celui de la batterie et qui correspond au premier paramètre d'état de la batterie, le modèle de défaillance est obtenu par apprentissage sur la base d'un second paramètre d'état de la batterie et d'un deuxième degré de défaillance,
le deuxième degré de défaillance est un degré de défaillance détecté qui est celui d'une batterie avec les mêmes spécifications et qui correspond au second paramètre d'état de la batterie, et un d'état de la batterie comprend au moins l'un des paramètres suivants :

une tension de décharge, un courant de décharge et une température de charge ; et l'envoi (S530) d'un premier message, dans lequel le premier message comprend le deuxième degré de défaillance ;
**caractérisé en ce que**
la détermination (S520) d'un premier degré de défaillance sur la base du premier paramètre d'état de la batterie et d'un modèle de défaillance comprend spécifiquement :

la détermination d'une résistance interne de batterie sur la base d'au moins un paramètre de la tension de décharge, du courant de décharge, et de la température de charge qui sont compris dans le premier paramètre d'état de la batterie, dans lequel la résistance interne de la batterie est utilisée pour déterminer le premier degré de défaillance ; et
dans lequel la résistance interne de la batterie est estimée sur la base d'un algorithme d'estimation d'état, et la résistance interne de la batterie ainsi que le premier paramètre d'état de la batterie sont entrés dans le modèle de défaillance pour déterminer le premier degré de défaillance.

**2.** Procédé selon la revendication 1, dans lequel le procédé comprend également :
l'envoi d'un deuxième message lorsque le premier degré de défaillance est supérieur ou égal à un premier seuil prédéfini, dans lequel le deuxième message est utilisé pour indiquer que la batterie présente un risque de défaillance.

**3.** Procédé selon l'une quelconque des revendications 1 à 2, dans lequel, avant la détermination d'un premier degré de défaillance sur la base du premier paramètre d'état de la batterie et d'un modèle de défaillance, le procédé comprend également :

la réception d'un troisième message, dans lequel le troisième message est utilisé pour demander la détection de la batterie.

4. Procédé selon l'une quelconque des revendications 1 à 3, dans lequel l'envoi d'un premier message comprend spécifiquement :

l'envoi du premier message dans un premier délai prédéfini après l'obtention du premier paramètre d'état de la batterie.

5. Procédé selon l'une quelconque des revendications 1 à 4, dans lequel le procédé comprend également :

l'entrée du second paramètre d'état de la batterie dans un modèle d'origine, pour obtenir un troisième degré de défaillance ;

l'ajustement d'un paramètre du modèle d'origine, de sorte qu'un écart entre le troisième degré de défaillance et le deuxième degré de défaillance se situe dans une plage prédéfinie ; et

l'utilisation du modèle original qui passe par l'ajustement comme modèle de défaillance.

6. Appareil de détection de batterie, configuré pour réaliser le procédé selon l'une quelconque des revendications 1 à 5.

7. Produit de programme informatique comprenant des instructions qui, lorsque le programme est exécuté par un ordinateur, amènent l'ordinateur à mettre en œuvre le procédé selon l'une quelconque des revendications 1 à 5.

8. Support de stockage lisible par ordinateur comprenant des instructions qui, lorsqu'elles sont exécutées par un ordinateur, amènent l'ordinateur à mettre en œuvre le procédé selon l'une quelconque des revendications 1 à 5.

A BMS collects a first terminal voltage of each battery in a battery pack, where the first terminal voltage is a terminal voltage of each battery after each battery is static for a preset duration starting from a time when a maximum voltage difference between terminal voltages of each battery is not greater than a threshold for start balancing

The BMS obtains a deviation between a first terminal voltage of each battery and an average voltage, where the average voltage is an average value of the first terminal voltages of all batteries in the battery pack

When a deviation corresponding to any battery is greater than a threshold safety value, the BMS determines that the battery has an internal short circuit risk

FIG. 1

FIG. 2

Failure probability

Neural network layer 330

Output layer 340

Hidden layer n (33n)

Hidden Layer 2 (332)

Hidden Layer 1 (331)

Convolutional layer/pooling layer 320

326

325

324

323

322

321

Convolutional neural network (CNN) 300

Input layer 310

Battery feature data

FIG. 3

FIG. 4

Obtain a first battery status parameter of a battery — S510

Determine a first failure degree based on the first battery status parameter and a failure model — S520

Send a first message, where the first message includes the first failure degree — S530

FIG. 5

Send a first message, where the first message is used to request to detect a battery — S610

Receive a second message, where the second message includes a first failure degree — S620

FIG. 6

**Battery feature data obtaining**

FIG. 7

**Service system 810**

Battery failure
detection application

| Data analysis module | Algorithm module | Failure model module |
|---|---|---|

| Data collection | Data processing | Data storage |
|---|---|---|

Vehicle 1      Vehicle 2     **Vehicle-mounted system 820**

Data collection

Data reporting

Service request

Data display

Data collection

Data reporting

Service request

Data display

FIG. 8

FIG. 9

Apparatus 1000

First obtaining module 1001

First processing module 1002

First sending module 1003

FIG. 10

Apparatus 1100

Second obtaining module 1101

Second receiving module 1102

FIG. 11

**EP 4 130 766 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016195587 A1
- US 10310022 B2
- CN 108258338 A